# EUROPÄISCHE PATENTANMELDUNG

(11) **EP 1 637 895 A1**
(43) Veröffentlichungstag der Anmeldung: **22.03.2006**
(21) Anmeldenummer: 05107365.8
(22) Anmeldetag: 10.08.2005
(51) Int. Cl.: G01R 31/3185

(54) **Verfahren zum Testen eines integrierten Schaltkreises**

(30) Priorität: 16.09.2004 DE 102004044813
(71) Anmelder: ROBERT BOSCH GMBH, 70442 Stuttgart (DE)
(72) Erfinder: Aue, Axel, 70825, Korntal-Muenchingen (DE); Poinstingl, Peter, 3910, Zwettl (AT)

(57) **Zusammenfassung**

Bei dem erfindungsgemäßen Verfahren zum Testen eines integrierten Schaltkreises (1) mittels eines logischen Moduls (3) ist vorgesehen, daß ein Teil (7) einer Logik (5) des integrierten Schaltkreises (1) durch das logische Modul (3) in mindestens einen Testmodus (11) versetzt wird. Durch das logische Modul (3) werden Testketten mit Testmustern (13) befüllt, außerdem ist vorgesehen, daß durch das logische Modul (3) ein Testergebnis (15) geliefert wird.

## Beschreibung

### Stand der Technik

Die Erfindung betrifft ein Verfahren zum Testen eines integrierten Schaltkreises, ein logisches Modul, einen integrierten Schaltkreis, eine Schaltungsanordnung, ein Computerprogramm sowie ein Computerprogrammprodukt.

Bei einem Produktionstest eines komplexen integrierten elektronischen Schaltkreises (IC) gibt es spezielle Testmodi, durch welche die komplexe interne Funktion dieses integrierten Schaltkreises in einfach testbare Testketten (Scan Test) geteilt wird.

Bei einer Endanwendung, also einer Verwendung des ICs in einer Applikation, ist typischerweise die Integrität des ICs zu prüfen. Dies ist speziell bei sicherheitskritischen Anwendungen, bspw. in Motorsteuergeräten, erforderlich.

Derzeit werden Tests mit speziell entwickelten Testprogramme realisiert, allerdings ist somit nur eine begrenzte Testtiefe erreichbar. Zudem ist der Aufwand bei einer Erstellung solcher Tests meist sehr hoch.

Die Erfindung schlägt ausgehend hiervon ein Verfahren zum Testen eines integrierten Schaltkreises mit den Merkmalen des Patentanspruchs 1, ein logisches Modul mit den Merkmalen des Patentanspruchs 8, einen integrierten Schaltkreis mit den Merkmalen des Patentanspruchs 9, eine Schaltungsanordnung mit den Merkmalen des Patentanspruchs 10, ein Computerprogramm mit den Merkmalen des Patentanspruchs 11 und ein Computerprogrammprodukt mit den Merkmalen des Patentanspruchs 12 vor.

### Vorteile der Erfindung

Bei dem erfindungsgemäßen Verfahren zum Testen eines integrierten Schaltkreises mittels eines logischen Moduls ist vorgesehen, daß ein Teil einer Logik des integrierten Schaltkreises durch das logische Modul in mindestens einen Testmodus versetzt wird. Durch das logische Modul werden Testketten mit Testmustern befüllt, außerdem ist vorgesehen, daß durch das logische Modul ein Testergebnis geliefert wird.

Somit ist es möglich, die Gesamtfunktionalität aller in dem integrierten elektronischen Schaltkreis (IC) vorhandenen Register abzuprüfen, die bei einem Integrationstest des gesamten Systems nicht testbar wären. Dabei erhöhen mehrere Testmodi die Testtiefe und verringern einen Aufwand bei der Erstellung der notwendigen Testmuster bzw. Testpattern, wobei diese Testmuster in modernen Designsystemen bei einer Synthese des integrierten Schaltkreises bzw. einer integrierten Schaltung erzeugt werden. Durch diese Vorgehensweise kann eine Testdauer verringert werden, da bspw. bei einer Testkette eine Funktion eines Setzens auf "1" bzw. "0" jedes Registers direkt geprüft werden kann und nicht über den Umweg eines Einstellens bestimmter Applikationsfunktionen zu erfolgen hat, was sich direkt auf die Kosten niederschlägt.

In bevorzugter Ausführung der Erfindung wird bei Durchführung des Verfahrens ein auf einem Halbleitersubstrat, das z.B. aus Silizium gefertigt ist, auf dem sich der integrierte Schaltkreis befindet, angeordnetes logisches Modul verwendet. Bei einem Befüllen der Testketten mit Testmustern werden dann für einzelne Testketten Testmuster bereitgestellt.

Bei einer möglichen Ausgestaltung der Erfindung ist vorgesehen, daß das logische Modul als Schnittstelle bzw. Interface ausgebildet ist. Alternativ hierzu kann das logische Modul bspw. als externe Recheneinheit bzw. externer Controller ausgebildet sein, durch die die integrierte Schaltung in den entsprechenden Testmodus versetzt wird und die als Master für einen Datentransfer dient.

Das logische Modul, das dem integrierten Schaltkreis zugeordnet ist und bspw. auch Teil dieses integrierten Schaltkreises sein kann, wird bei einer möglichen Funktion als Interface über Software, Boot-ROM, Debugging oder eine eigene Schnittstelle bzw. ein eigenes Interface bedient.

Bei Durchführung des erfindungsgemäßen Verfahrens werden in einem kleinen Teil der Logik des integrierten Schaltkreises in dem das logische Modul angeordnet sein kann, herkömmliche Funktionen aufrecht erhalten. Dieser kleine Teil übernimmt eine Steuerung des integrierten Schaltkreises, während der restliche Teil der Logik des integrierten Schaltkreises, bspw. eine Peripherie, durch das logische Modul in den Testmodus versetzt wird.

Es ist möglich, das erfindungsgemäße Verfahren während eines laufenden Betriebs des integrierten Schaltkreises und/oder bei einer Endanwendung des integrierten Schaltkreises durchzuführen. In einem letzteren Fall kann vorgesehen sein, daß das erfindungsgemäße Verfahren nach Verbau eines Dies bzw. Chips, also eines Plättchens aus Halbleitersubstrat, wie bspw. ein Siliziumkristall, auf dem sich der integrierte Schaltkreis mit dem zugeordneten logischen Modul befindet, in einer Schaltungsanordnung, z.B. in einem Hybridsteuergerät oder einem Multichipmodul, also in einer Anwendung bzw. Applikation durchgeführt wird.

Mit der Erfindung wird somit bei der genannten Endanwendung durch Verwendung der auf den integrierten Schaltkreis zugeschnittenen Testmuster eine hohe Testabdeckung bei geringer Testzeit erreicht. Durch diese Testmustern werden die üblicherweise zur Anwendung kommenden, speziell entwickelten Testprogramme ersetzt oder zumindest unterstützt. Dies führt in weiterer Folge zu einer Kostenreduktion. Des weiteren kann mit der Erfindung eine korrekte Funktion des integrierten Schaltkreises bei laufendem Betrieb gestestet werden.

Das erfindungsgemäße logische Modul zum Testen eines integrierten Schaltkreises ist dazu ausgelegt, einen Teil einer Logik dieses integrierten Schaltkreises in mindestens einen Testmodus zu versetzen, Testketten mit Testmustern zu befüllen und ein Testergebnis zu liefern.

Dieses logische Modul kann als kleine Logik in einem Halbleitersubstrat aus Silizium, in dem sich der integrierte Schaltkreis befindet, oder als externe Logik ausgebildet sein. Mit diesem logischen Modul kann ein "restlicher" Chip mit dem integrierten Schaltkreis in eine beliebige Anzahl von Testmodi versetzt werden. Für einzelne Testketten werden durch Befüllen Testmuster und Testpattern bereitgestellt. Testergebnisse können durch das logische Modul zurückgeliefert werden.

Der erfindungsgemäße integrierte Schaltkreis weist eine Logik auf. Diesem integrierten Schaltkreis ist ein logisches Modul zugeordnet, mit dem ein Test dieses integrierten Schaltkreises durchzuführen ist. Der integrierte Schaltkreis ist derart ausgelegt, daß das logische Modul einen Teil der Logik in mindestens einen Testmodus versetzt, Testketten mit Testmustern befüllt und ein Testergebnis liefert.

In der erfindungsgemäßen Schaltungsanordnung ist ein auf einem Die bzw. einem Chip aus einem Halbleitersubstrat befindlicher integrierter Schaltkreis, dem ein logisches Modul zugeordnet ist, verbaut. Eine Durchführung eines Tests für diese Schaltungsanordnung ist durch Durchführung eines Tests des integrierten Schaltkreises mit dem logischen Modul realisierbar. Dabei versetzt das logische Modul einen Teil einer Logik des integrierten Schaltkreises in mindestens einen Testmodus, befüllt Testketten mit Testmustern und liefert ein Testergebnis.

Durch die Erfindung ist eine Verwendung von IC-Testmustern in Anwendungen möglich, dabei kann eine Teststrategie bzw. Testmuster eines IC-Herstellers bei einer Endanwendung ganz oder zumindest teilweise übernommen werden. Durch unmittelbare Verwendung derartiger Testmuster des IC-Herstellers bei der Einsparung in eine Testprogrammentwicklung für Tests einer Gesamtfunktionalität integrierter Schaltkreise zu erreichen.

Die Testmuster können z.B. bei einem Fertigungstest einer Endanwendung, wie bspw. einem Steuergeräte-Funktionstest, zur Anwendung kommen.

Durch die Erfindung können Prüflücken innerhalb eines IC-Testprogramms erkannt und/oder bei der Endanwendung geschlossen werden. Somit ist es möglich, Bauteile, die sich noch in einem Fertigungsverfahren, also innerhalb einer sogenannten Pipeline, wie Ausgangslager des IC-Herstellers, Transporte von dem IC-Hersteller zu einem Endanwendungsproduzenten bzw. Lagerung bei diesem Endanwendungsproduzenten befinden, den erweiterten Testmustern zu unterziehen, ohne diese Bauteile an den IC-Hersteller rückliefern oder in einem Testhaus prüfen zu müssen.

Die erfindungsgemäße Verwendung von Testmustern kann auch während eines Betriebs der Endanwendung zur Sicherstellung der Fehlerfreiheit des integrierten Schaltkreises in dieser Endanwendung bzw. Applikation, bspw. während der Lebenszeit eines Fahrzeugs, in das der integrierte Schaltkreis oder die Schaltungsanordnung eingebaut ist, erfolgen.

Mit der Erfindung ist es auch möglich, einen kompletten Test des integrierten Schaltkreises auch nach Verbau dieses integrierten Schaltkreises als Die bzw. Chip in einem Steuergerät, wie bspw. einem Hybridsteuergerät, durchzuführen. Dies hat zum Vorteil, daß somit diverse Produktionsprozesse für derartige Steuergeräte besser überprüft werden können und Fehler, die zu einer Schädigung integrierten Schaltkreises durch einen Produktionsprozeß geführt haben, detektiert werden können.

Des weiteren ist eine Anwendung der Erfindung nach Verbauung des integrierten Schaltkreises als Die in einer als Multichipmodul (MCM) ausgebildeten Schaltungsanordnung denkbar. Dabei kann ein bereits fertiges Multichipmodul auch nach Zusammenbau gut getestet werden, da ein Test für den integrierten Schaltkreis aktiviert werden kann.

Somit ist eine höhere Testtiefe als bei einem Test der Gesamtfunktionalität möglich. Es können auch Tests in einer Applikation bei Betrieb unter Verringerung der Testdauer möglich sein.

Das erfindungsgemäße Computerprogramm mit Programmcodemitteln ist zur Durchführung aller Schritte des erfindungsgemäßen Verfahrens ausgelegt, wenn dieses Computerprogramm auf einem Computer oder einer entsprechenden Recheneinheit, insbesondere einer Recheneinheit der erfindungsgemäßen Einrichtungen, durchgeführt wird.

Das erfindungsgemäße Computerprogrammprodukt mit Programmcodemitteln, die auf einem computerlesbaren Datenträger abgespeichert sind, ist zur Durchführung des erfindungsgemäßen Verfahrens vorgesehen, wenn das Computerprogramm auf einem Computer oder einer entsprechenden Recheneinheit, insbesondere einer Recheneinheit in der erfindungsgemäßen Einrichtungen, durchgeführt wird.

Weitere Vorteile und Ausgestaltungen der Erfindung ergeben sich aus der Beschreibung und der beiliegenden Zeichnung.

Es versteht sich, daß die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispiels in der Zeichnung schematisch dargestellt und wird im folgenden unter Bezugnahme auf die Zeichnung ausführlich beschrieben.

### Zeichnung

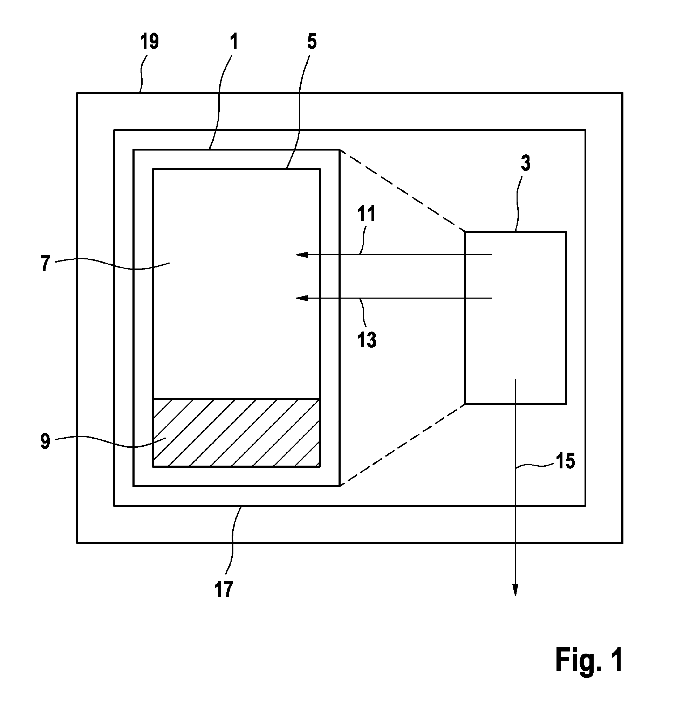

- Figur 1: zeigt eine mögliche Ausführungsform der Erfindung in schematischer Darstellung.

### Beschreibung des Ausführungsbeispiels

Figur 1 zeigt in schematischer Darstellung einen integrierten Schaltkreis 1, dem ein logisches Modul 3 zugeordnet ist. Dabei kann dieses logische Modul 3 auch Bestandteil des integrierten Schaltkreises 1 sein. Der integrierte Schaltkreis 1 sowie das logische Modul 3 befinden sich auf einem Die 17 aus einem Halbleitersubstrat, bspw. aus Silizium, also auf einem einer Vielzahl von Chips, die aus einem Halbleiterwafer mit elektronischen Schaltkreisen und/oder Elementen herausgesägt wurden. In dieser Darstellung ist der Die 17 mit dem integrierten Schaltkreis 1 und dem logischen Modul in einer Schaltungsanordnung 19, bspw. einem Hybridsteuergerät oder einem Multichipmodul, verbaut und somit in einer möglichen Endanwendung integriert.

Der integrierte Schaltkreis (IC) 1 weist eine eine Vielzahl schaltungsrelevanter Register umfassende Logik 5 auf. Bei Durchführung des erfindungsgemäßen Verfahrens zum Testen des integrierten Schaltkreises 1 wird ein erster Teil 7 der Logik 5 durch das logische Modul 3 in mindestens einen Testmodus 11 versetzt. Zudem werden zur Durchführung eines Tests durch das logische Modul 3 Testketten mit Testmustern 13 bzw. Testpattern befüllt bzw. werden durch das logische Modul 3 derartige Testmuster 13 für Testketten bereitgestellt. Durch spezielle Testmodi 11 werden komplexe interne Funktionen des integrierten Schaltkreises 1 in einfache testbare Testketten (Scan Test) geteilt. Ein Testergebnis 15 des erfindungsgemäße durchführbaren Tests wird durch das logische Modul 3 zurückgeliefert. Ein zweiter Teil 9 der Logik 5 bleibt während des Tests aktiv. Demnach kann das erfindungsgemäße Verfahren auch bei Betrieb des integrierten Schaltkreises 1 oder der Schaltungsanordnung 19 durchgeführt werden.

## Patentansprüche

1. Verfahren zum Testen eines integrierten Schaltkreises (1) mittels eines logischen Moduls (3), bei dem ein Teil (7) einer Logik (5) des integrierten Schaltkreises (1) durch das logische Modul (3) in mindestens einen Testmodus (11) versetzt wird, durch das logische Modul (3) Testketten mit Testmustern (13) befüllt werden und durch das logische Modul (3) ein Testergebnis (15) geliefert wird.

2. Verfahren nach Anspruch 1, bei dem ein auf einem Halbleitersubstrat (17), auf dem sich der integrierte Schaltkreis (1) befindet, angeordnetes logisches Modul (3) verwendet wird.

3. Verfahren nach Anspruch 1 oder 2, bei dem ein als Schnittstelle ausgebildetes logisches Modul (3) verwendet wird.

4. Verfahren nach Anspruch 1 oder 2, bei dem ein als externe Recheneinheit ausgebildetes logisches Modul (3) verwendet wird, wobei Daten von dem als Master zur Datenübertragung dienenden logischen Modul (3) übertragen werden.

5. Verfahren nach einem der voranstehenden Ansprüche, das während eines laufenden Betriebs des integrierten Schaltkreises (1) durchgeführt wird.

6. Verfahren nach einem der voranstehenden Ansprüche, das bei einer Endanwendung des integrierten Schaltkreises (1) durchgeführt wird.

7. Verfahren nach einem der voranstehenden Ansprüche, das nach Verbau eines Dies (17) aus dem Halbleitersubstrat, auf dem sich der integrierte Schaltkreis (1) befindet, in einer Schaltungsanordnung (19) durchgeführt wird.

8. Logisches Modul (3) zum Testen eines integrierten Schaltkreises (1), das dazu ausgelegt ist, einen Teil (7) einer Logik (5) dieses integrierten Schaltkreises (1) in mindestens einen Testmodus (11) zu versetzen, Testketten mit Testmustern (13) zu befüllen und ein Testergebnis (17) zu liefern.

9. Integrierter Schaltkreis (1), der eine Logik (5) aufweist, dem ein logisches Modul (3) zugeordnet ist und für den ein Test mit diesem logischen Modul (3) durchführbar ist, wobei das logische Modul (3) einen Teil (7) der Logik (5) in mindestens einen Testmodus (11) versetzt, Testketten mit Testmustern (13) befüllt und ein Testergebnis (15) liefert.

10. Schaltungsanordnung (19), in der ein auf einem Die (17) aus einem Halbleitersubstrat befindlicher integrierter Schaltkreis (1), dem ein logisches Modul (3) zugeordnet ist, verbaut ist, für die eine Durchführung eines Tests durch Durchführung eines Tests des integrierten Schaltkreises (1) mit dem logischen Modul (3) realisierbar ist, wobei das logische Modul (3) einen Teil (7) einer Logik (5) des integrierten Schaltkreises (1) in mindestens einen Testmodus (11) versetzt, Testketten mit Testmustern (13) befüllt und ein Testergebnis liefert.

11. Computerprogramm mit Programmcodemitteln, um alle Schritte eines Verfahrens nach einem der Ansprüche 1 bis 7 durchzuführen, wenn das Computerprogramm auf einem Computer oder einer entsprechenden Recheneinheit, insbesondere in einer Einrichtung nach einem der Ansprüche 8 bis 10, durchgeführt wird.

12. Computerprogrammprodukt mit Programmcodemitteln, die auf einem computerlesbaren Datenträger gespeichert sind, um ein Verfahren nach einem der Ansprüche 1 bis 7 durchzuführen, wenn das Computerprogramm auf einem Computer oder einer entsprechenden Recheneinheit, insbesondere in einer Einrichtung nach einem der Ansprüche 8 bis 10, durchgeführt wird.
